# FASCICULE DE BREVET EUROPEEN

(11) **EP 3 594 997 B1**
(45) Date de publication et mention de la délivrance du brevet: **24.03.2021**
(21) Numéro de dépôt: 19185598.0
(22) Date de dépôt: 10.07.2019
(51) Int. Cl.: H01L 21/78, H01L 33/00, H01L 33/12

(54) **PROCEDE DE FABRICATION D'AU MOINS UNE STRUCTURE SEMICONDUCTRICE COMPORTANT UNE ETAPE DE SEPARATION VIS-A-VIS DU SUBSTRAT DE CROISSANCE**
HERSTELLUNGSVERFAHREN VON MINDESTENS EINER HALBLEITERSTRUKTUR, UMFASSEND EINEN ABTRENNSCHRITT VOM WACHSTUMSSUBSTRAT
METHOD FOR MANUFACTURING AT LEAST ONE SEMICONDUCTOR STRUCTURE COMPRISING A STEP OF SEPARATION FROM THE GROWTH SUBSTRATE

(30) Priorité: 13.07.2018 FR 1856466
(43) Date de publication de la demande: 15.01.2020
(73) Titulaire: Commissariat à l'Énergie Atomique et aux Énergies Alternatives, 75015 Paris cedex (FR)
(72) Inventeur: OBRECHT, Remy, 38054 Grenoble, cedex 9 (FR); PERNEL, Carole, 38054 Grenoble, cedex 9 (FR)
(74) Mandataire: INNOV-GROUP

(56) Documents cités:
- EP-A2- 2 770 545
- US-A1- 2011 223 749
- US-B1- 6 956 246
- SAPTARSHI DAS ET AL: "A Self-Limiting Electro-Ablation Technique for the Top-Down Synthesis of Large-Area Monolayer Flakes of 2D Materials", SCIENTIFIC REPORTS, vol. 6, no. 1, 21 juin 2016 (2016-06-21), page 1, XP055563998, DOI: 10.1038/srep28195
- JEEHWAN KIM ET AL: "Principle of direct van der Waals epitaxy of single-crystalline films on epitaxial graphene", NATURE COMMUNICATIONS, vol. 5, 1 septembre 2014 (2014-09-01), pages 4836-4836, XP055468472, GB ISSN: 2041-1723, DOI: 10.1038/ncomms5836

## Description

### DOMAINE TECHNIQUE

Le domaine de l'invention porte sur la fabrication d'au moins une structure semiconductrice par épitaxie de type van der Waals, comportant une étape de séparation de la ou des structures semiconductrices épitaxiées vis-à-vis du substrat de croissance.

### ÉTAT DE LA TECHNIQUE ANTÉRIEURE

D'une manière générale, l'épitaxie d'un matériau cristallin à partir d'une couche de nucléation d'un substrat de croissance correspond à la croissance de ce matériau de sorte que son réseau cristallin présente une relation d'épitaxie avec celui du matériau sous-jacent. Autrement dit, le matériau épitaxié présente un alignement des orientations cristallographiques de son réseau cristallin, dans au moins une direction comprise dans le plan du matériau, et dans au moins une direction orthogonale au plan du matériau, avec celles du réseau cristallin du matériau de nucléation. Le plan du matériau épitaxié est ici parallèle au plan de nucléation. Cela se traduit par le fait qu'il y a un accord d'orientation et de position cristallographique entre le réseau cristallin du matériau épitaxié et celui du matériau de nucléation.

Cependant, lorsque le matériau cristallin présente un paramètre de maille différent de celui du matériau de nucléation, le matériau épitaxié présente alors une déformation de son réseau cristallin, de sorte qu'il subit alors des contraintes mécaniques en tension ou en compression. Par ailleurs, lorsque l'épaisseur du matériau épitaxié dépasse une valeur dite épaisseur critique, les contraintes mécaniques peuvent relaxer de manière plastique, se traduisant alors par la formation de défauts structuraux tels que des dislocations de désaccord de maille. La qualité cristalline de la couche épitaxiée peut alors être dégradée.

A titre d'exemple, la croissance épitaxiale d'une couche cristalline en un composé III-N, par exemple du nitrure de gallium GaN ou du nitrure d'indium et de gallium InGaN, peut être effectuée, entre autres, à partir d'un substrat en saphir (Al₂O₃) ou en silicium. Cependant, le GaN présente un désaccord de maille de l'ordre de 15% avec le saphir, ainsi qu'une importante différence du coefficient de dilatation thermique. Le GaN épitaxié présente alors des contraintes mécaniques qui, à partir d'une épaisseur critique de la couche, peuvent relaxer de manière plastique en formant des dislocations. De tels défauts structuraux sont susceptibles de dégrader les propriétés optiques et/ou électroniques d'un dispositif microélectronique ou optoélectronique comportant une telle couche épitaxiée.

Dans le but de diminuer la densité des défauts structuraux, l'article de Kim et al. intitulé Principle of direct van der Waals epitaxy of single-crystalline films on epitaxial graphene, Nat. Comm. 2014, 5:4836 décrit la fabrication d'une diode électroluminescente à base de GaN par épitaxie à partir d'une couche de nucléation en un matériau bidimensionnel, ici du graphène, celle-ci étant formée sur un substrat support en carbure de silicium SiC. La croissance épitaxiale est dite de type van der Waals dans la mesure où la couche de GaN épitaxiée à partir de la couche de nucléation ne présente pas de relations d'épitaxie avec cette dernière.

La diode électroluminescente obtenue est ensuite séparée de son substrat de croissance par une étape de séparation mécanique. Plus précisément, une couche de mise en contrainte réalisée en nickel est déposée sur la surface supérieure de la diode électroluminescente, ainsi qu'une couche de manipulation. La couche de nickel impose alors des contraintes mécaniques dans la diode électroluminescente qui provoquent la séparation mécanique de cette dernière vis-à-vis du substrat de croissance. La séparation est dite mécanique dans la mesure où elle est obtenue par la génération de contraintes mécaniques dans la diode électroluminescente telles que leur énergie est supérieure à l'énergie des liaisons van der Waals entre la diode électroluminescente et le substrat de croissance. Cependant, les contraintes mécaniques générées dans la diode électroluminescente par une couche de mise en contrainte sont susceptibles d'induire une dégradation des propriétés optiques et/ou électroniques de la diode électroluminescente.

EP 2 770 545 A2 décrit un procédé de fabrication d'au moins une structure semiconductrice séparée d'un substrat support.

### EXPOSÉ DE L'INVENTION

L'invention a pour objectif de remédier au moins en partie aux inconvénients de l'art antérieur, et plus particulièrement de proposer un procédé de fabrication d'au moins une structure semiconductrice par épitaxie de type van der Waals, comportant une étape de séparation de la structure semiconductrice vis-à-vis de son substrat de croissance, de sorte que les propriétés optiques et/ou électroniques de la structure semiconductrice soient sensiblement préservées à la suite de l'étape de séparation.

Plus précisément, l'objet de l'invention est un procédé de fabrication d'au moins une structure semiconductrice séparée d'un substrat support, comportant les étapes suivantes :
i) réalisation, à partir d'un substrat support, d'une couche de nucléation formée d'un matériau bidimensionnel comportant au moins trois monocouches ; dont au moins une monocouche intercalaire, chaque monocouche étant formée d'un réseau cristallin bidimensionnel
ii) réalisation, par épitaxie à partir de la couche de nucléation, d'au moins une structure semiconductrice, de manière à être bordée par une zone latérale dans laquelle la couche de nucléation présente une surface libre, une face supérieure du substrat support, sur laquelle repose la couche de nucléation, comportant une première surface non recouverte par la couche de nucléation, de sorte que la surface libre présente une face supérieure et une bordure latérale
iii) obtention d'une surface conductrice d'une première électrode, située dans ladite zone latérale et distincte de ladite surface libre ;
iv) disposition de la structure ainsi obtenue dans un bain d'électrolyte aqueux, dans lequel est disposée une deuxième électrode, l'électrolyte aqueux venant alors au contact, dans la zone latérale, de la surface libre de la couche de nucléation et de la surface conductrice de la première électrode ;
v) application d'une différence de potentiel entre lesdites électrodes, adaptée à provoquer la formation de radicaux hydroxyles à l'interface entre la surface conductrice et l'électrolyte aqueux, lesquels réagissent alors avec la face supérieure et la bordure latérale de la surface libre de la couche de nucléation, dégradant alors au moins une monocouche intercalaire de la couche de nucléation jusqu'à provoquer la séparation de la structure semiconductrice vis-à-vis du substrat support.

Certains aspects préférés mais non limitatifs de ce procédé sont les suivants.

De préférence, l'étape iii) d'obtention de la surface conductrice comporte la réalisation d'une portion métallique formant la première électrode, située dans la zone latérale et au contact de la première surface du substrat support.

La surface conductrice de la première électrode peut être située à distance de la surface libre de la couche de nucléation.

La première surface peut être définie par un matériau électriquement conducteur du substrat support lequel forme la première électrode, la première surface formant alors la surface conductrice.

Le matériau bidimensionnel peut être électriquement conducteur et la couche de nucléation peut former la première électrode, la surface libre de la couche de nucléation formant alors la surface conductrice.

Lors de l'étape ii) de réalisation de la structure semiconductrice, celle-ci peut recouvrir partiellement la couche de nucléation, de sorte que la surface libre de la couche de nucléation est formée au moins en partie par une partie de sa face dite supérieure opposée au substrat support.

Le matériau bidimensionnel de la couche de nucléation peut être choisi parmi les chalcogénures de métaux de transition, le graphène, et le nitrure de bore.

La structure semiconductrice peut être une diode adaptée à émettre ou à détecter de la lumière, et peut être réalisée à base d'un composé semiconducteur III-V ou à base d'un composé semiconducteur II-VI.

Lors de l'étape ii), une pluralité de structures semiconductrices peuvent être réalisées à partir de couches de nucléation formées en le matériau bidimensionnel et distinctes les unes des autres, chaque structure semiconductrice étant bordée par une zone latérale dans laquelle est située : une surface conductrice, et une première surface de la face supérieure du substrat support, la première surface étant non recouverte par la couche de nucléation.

Lors de l'étape ii), une pluralité de structures semiconductrices peuvent être réalisées, puis, au moins l'une desdites structures semiconductrices peut être séparée du substrat support de manière sélective, par l'application d'une différence de potentiel entre une première électrode située dans la zone latérale qui borde la structure semiconductrice à séparer, et la deuxième électrode. Par séparation sélective, on entend que la structure semiconductrice est séparée alors que d'autres structures semiconductrices ne le sont pas. Seule la première électrode située dans la zone latérale de la structure semiconductrice à séparer est polarisée. Les premières électrodes situées dans les zones latérales des structures semiconductrices non séparées ne sont alors pas polarisées. Les premières électrodes sont ainsi distinctes et peuvent être polarisées indépendamment les unes des autres.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1K illustrent différentes étapes d'un procédé de fabrication collective de plusieurs structures semiconductrices, selon un mode de réalisation, comportant une étape de séparation de celles-ci vis-à-vis du substrat de croissance ;
la figure 2 est une vue schématique et partielle, en coupe transversale, d'une variante de la fig.1G, dans laquelle la surface conductrice d'une électrode de travail est formée par le substrat support.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par Sauf indication contraire, les termes « sensiblement », « environ », « de l'ordre de » signifient à 10% près. Par ailleurs, l'expression « comportant un » doit être comprise comme « comportant au moins un », sauf indication contraire.

L'invention porte sur un procédé de fabrication d'au moins une structure semiconductrice par épitaxie de type van der Waals, à partir d'un substrat de croissance comportant une couche de nucléation en un matériau bidimensionnel. Le procédé comprend une étape de séparation de la ou des structures semiconductrices vis-à-vis du substrat de croissance, et en particulier d'un substrat support de ce dernier. Comme décrit en détail plus loin, l'étape de séparation met en œuvre un phénomène d'ablation électrochimique de la couche de nucléation.

D'une manière générale, l'épitaxie de type van der Waals, également appelée épitaxie van der Waals, est une technique d'hétéroépitaxie par laquelle une couche semiconductrice cristalline est liée à une couche de nucléation formée d'une ou plusieurs monocouches d'un matériau bidimensionnel par des liaisons de type van der Waals et non pas par des liaisons covalentes. L'épitaxie van der Waals permet notamment de s'affranchir du désaccord de maille pouvant exister entre le matériau bidimensionnel et la couche cristalline épitaxiée, ce désaccord de maille étant issu de la différence entre les paramètres de maille des deux matériaux, ce qui permet ainsi d'obtenir une couche cristalline épitaxiée relaxée ou quasi-relaxée. Une telle couche cristalline obtenue par épitaxie van der Waals présente alors une densité réduite de défauts structuraux tels que des dislocations de désaccord de maille, optimisant ainsi les propriétés optiques et/ou électroniques de la structure semiconductrice comportant une telle couche cristalline épitaxiée.

Le matériau de la couche de nucléation est un matériau cristallin dit bidimensionnel dans la mesure où il est formé d'une monocouche ou de plusieurs monocouches empilées les unes sur les autres, chaque monocouche (également appelée feuille ou feuillet) étant formée d'atomes ou de molécules agencés de manière à former un réseau cristallin bidimensionnel. Autrement dit, le réseau cristallin de chaque monocouche s'étend suivant deux directions et non pas suivant les trois directions de l'espace. Le réseau cristallin d'une monocouche est donc distinct de celui d'une monocouche adjacente. Une monocouche est une structure cristalline bidimensionnelle d'épaisseur monoatomique, et est liée à la ou les monocouches adjacentes par une force de type Van der Waals et non pas par une liaison covalente. Le matériau bidimensionnel peut être choisi parmi les chalcogénures de métaux de transition, tels que le sulfure ou séléniure de molybdène (MoS₂, MoSe₂) ou de tungstène (WS₂), le graphène, le nitrure de bore (en particulier le nitrure de bore hexagonal), entre autres. Dans le cadre de l'invention, le matériau bidimensionnel comporte au moins trois monocouches, c'est-à-dire qu'il est formé d'un empilement d'au moins trois monocouches, à savoir une monocouche dite inférieure au contact d'un substrat support, une monocouche dite supérieure au contact de la ou des structures semiconductrices, et une ou plusieurs monocouches dites intercalaires, situées entre les monocouches inférieure et supérieure. Un tel matériau bidimensionnel est donc différent des composés cristallins dont le réseau cristallin est tridimensionnel.

Comme détaillé plus loin, la séparation de la ou des structures semiconductrices vis-à-vis du substrat de croissance est réalisée par ablation électrochimique de la couche de nucléation. Par ablation électrochimique, on entend une réaction entre une espèce formée de manière électrochimique et pilotée par un potentiel et le matériau bidimensionnel de la couche de nucléation entraînant la suppression partielle ou totale d'au moins une monocouche de la couche de nucléation, en particulier d'au moins une monocouche intercalaire. Cette réaction d'ablation électrochimique se distingue ainsi d'une action d'exfoliation mécanique, dans laquelle on détache ou sépare mécaniquement la structure semiconductrice du substrat de croissance en générant dans cette dernière des contraintes mécaniques, lesquelles sont susceptibles d'induire une dégradation des propriétés optiques et/ou électroniques de la structure semiconductrice.

Dans la suite de la description, la ou les structures semiconductrices peuvent être des dispositifs microélectroniques ou optoélectroniques. Il peut ainsi s'agir, à titre purement illustratif, de diodes électroluminescentes ou de photodiodes, par exemple réalisées majoritairement à base d'un composé semiconducteur III-V tel que du GaN. Autrement dit, la structure semiconductrice est réalisée en un matériau dont au moins 50% de son volume est formé ou comporte du GaN ou un alliage de GaN, par exemple de l'InGaN ou de l'AlGaN.

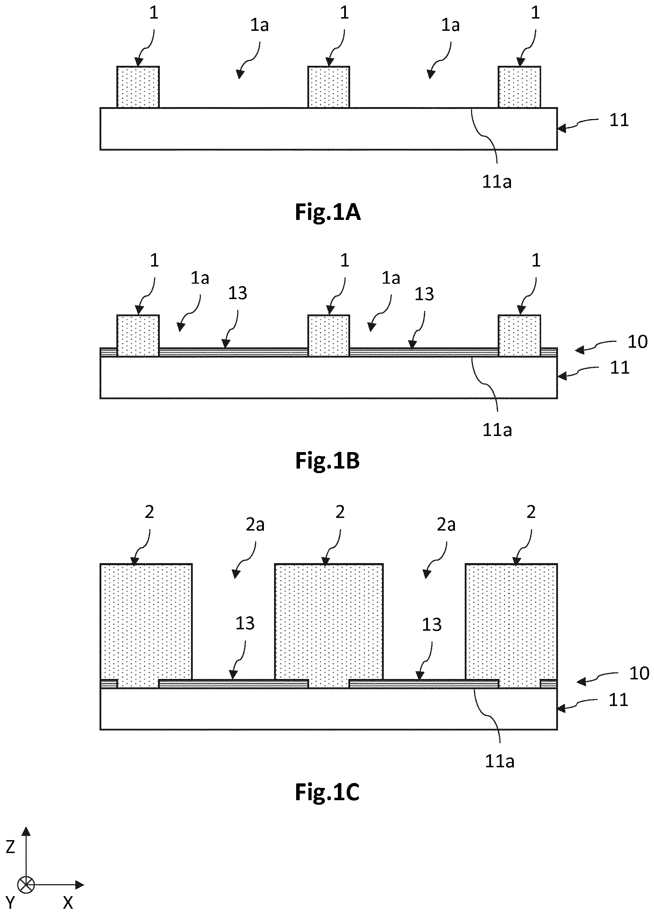

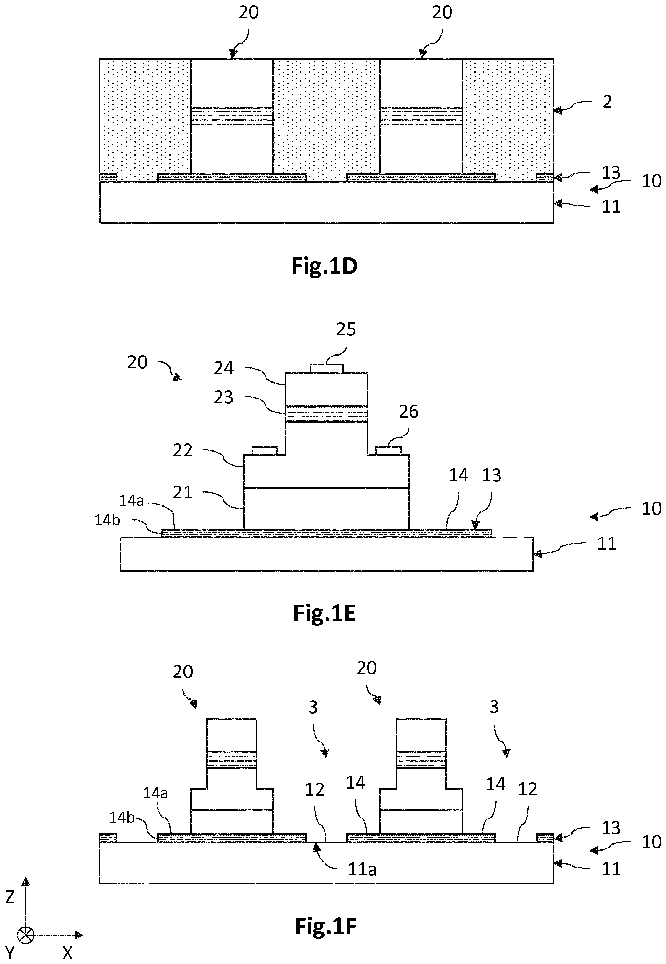

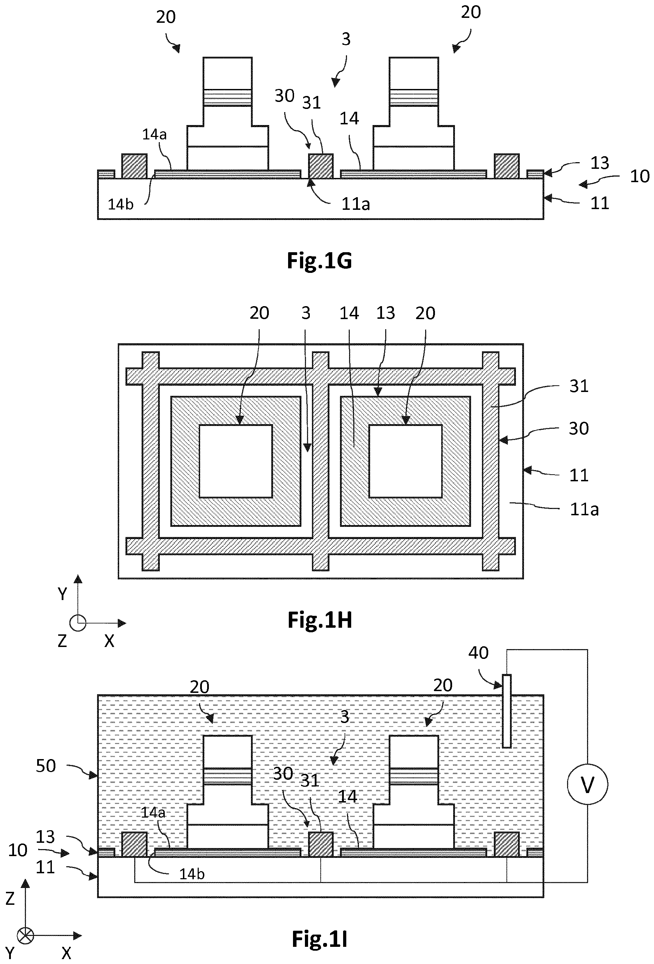

Les figures 1A à 1K sont des vues schématiques et partielles, en coupe, de différentes étapes d'un procédé de fabrication collective de structures semiconductrices 20 selon un mode de réalisation. Dans cet exemple, la structure semiconductrice 20 est une diode électroluminescente réalisée à base d'InGaN.

On définit ici et pour la suite de la description un repère direct tridimensionnel orthogonal (X,Y,Z), où les axes X et Y forment un plan parallèle au plan principal du substrat support 11, et où l'axe Z est orienté de manière sensiblement orthogonale au plan principal du substrat support 11. Dans la suite de la description, les termes « inférieur » et « supérieur » s'entendent comme étant relatifs à un positionnement croissant lorsqu'on s'éloigne du substrat support 11 suivant la direction +Z.

En référence aux fig. 1A et 1B, on réalise tout d'abord un substrat de croissance 10 qui comporte un substrat support 11 revêtu au moins en partie par une couche de nucléation 13.

Le substrat support 11 comporte une face supérieure 11a destinée à recevoir la couche de nucléation 13. Il peut être réalisé en un même matériau, et être ainsi un substrat massif (*bulk substrate,* en anglais), ou être formé d'un empilement de plusieurs couches de matériaux différents, tel qu'un substrat de type SOI (*Silicon On Insulator,* en anglais). Le matériau définissant la face supérieure 11a peut être électriquement isolant ou conducteur. A titre d'exemple, un tel matériau isolant peut être choisi parmi le saphir (Al₂O₃), le borosilicate, la silice, le verre, le quartz, un oxyde ou un nitrure de silicium ou d'aluminium, entre autres.

Il peut être réalisé en un matériau conducteur tel qu'un semiconducteur éventuellement dopé. A titre d'exemple, un tel matériau semiconducteur peut être choisi parmi le silicium, en germanium, en carbure de silicium, ou plus largement en un composé III-V comportant au moins un élément de la colonne III et au moins un élément de la colonne V du tableau périodique, un composé II-VI, ou en un élément ou un composé IV. A titre d'exemple, des composés III-V peuvent être des composés III-N, tels que le GaN, InGaN, AlN, InN ou l'AlInGaN, ou des composés comportant un élément de la colonne V, par exemple l'AsGa ou l'InP. Des composés II-VI peuvent être le CdTe, HgTe, CdHgTe, ZnO, ZnMgO, CdZnO ou CdZnMgO. Enfin, des éléments ou composés IV peuvent être le Si, C, Ge, SiC, SiGe, GeC, entre autres. Le matériau semiconducteur peut être dopé pour augmenter sa conductivité électrique. Enfin, le matériau du substrat support 11 définissant la face supérieure 11a peut être choisi parmi les matériaux métalliques (Ti, Au, TiAu...) et les matériaux semi-métalliques (TiN...). De préférence, le substrat support 11 est ici un substrat monobloc réalisé en saphir.

On réalise ensuite, sur la face supérieure 11a, un premier masque de croissance 1, destiné à définir ultérieurement une surface libre de la face supérieure 11a du substrat support 11 pouvant recevoir une électrode de travail. Pour cela, on dépose une couche diélectrique sur la face supérieure 11a du substrat support 11. La couche diélectrique est réalisée en au moins un matériau électriquement isolant, par exemple un oxyde ou un nitrure de silicium, tel que du SiO₂ ou du Si₃N₄, voire un oxynitrure de silicium, un oxyde d'aluminium, ou un oxyde d'hafnium. Elle peut présenter une dimension suivant l'axe Z, i.e. une épaisseur comprise entre quelques centaines de nanomètres et quelques microns ou dizaines de microns, par exemple égale à 10µm environ.

On réalise ensuite, par des techniques de photolithographie et de gravure, des ouvertures traversantes 1a dans la couche diélectrique, de manière à rendre localement libre des surfaces de la face supérieure 11a du substrat support 11, destinées à recevoir la couche de nucléation 13. Par surface libre, on entend une surface non revêtue par un autre matériau. Le premier masque de croissance 1 localisée forme alors un maillage de bandes diélectriques. Les surfaces libres peuvent présenter, dans le plan XY, une forme circulaire, ovale ou polygonale, par exemple carrée ou rectangulaire. A titre d'exemple, elles présentent une forme carrée de 100µm environ de côté. Les dimensions de la surface libre dépendent notamment de celles des structures semiconductrices que l'on souhaite fabriquer. Chaque bande diélectrique 1 présente une largeur initiale, i.e. sa dimension transversale dans le plan XY et orthogonale à sa dimension longitudinale, de l'ordre de quelques microns ou dizaines de microns. A titre d'exemple, les bandes diélectriques 1 présentent une épaisseur initiale égale à 15µm environ et une largeur initiale égale à 15µm environ. La largeur initiale des bandes diélectriques dépend notamment des dimensions de l'électrode de travail destinée à être réalisée ultérieurement.

On dépose ensuite la couche de nucléation 13 sur les surfaces libres de la face supérieure 11a du substrat support 11 (fig.iB). La couche de nucléation 13 peut être déposée par croissance épitaxiale par jets moléculaires (MBE, pour *Molecular Beam Epitaxy,* en anglais). D'autres techniques de dépôt sont possibles, par exemple par dépôt chimique en phase vapeur (CVD, pour *Chemical Vapor Deposition,* en anglais) tel que le dépôt chimique aux précurseurs organométalliques (MOCVD), ou tout autre technique de dépôt adaptée. Dans cet exemple, la couche de nucléation 13 est réalisée en sulfure de tungstène WS₂ qui est particulièrement adapté à la nucléation d'un composé semiconducteur à base d'InGaN. Elle est formée d'un empilement d'au moins trois monocouches, à savoir une monocouche inférieure au contact de la face supérieure 11a, au moins une monocouche intercalaire, et une monocouche supérieure. La couche de nucléation 13 présente, de préférence, un nombre de monocouches choisi de sorte que la séparation des structures semiconductrices 20 vis-à-vis du substrat support 11 par ablation électrochimique est effectuée avant que celles-ci ne s'oxydent, le cas échéant.

En référence aux fig. 1C à 1F, on réalise ensuite les structures semiconductrices 20 par épitaxie van der Waals. Celles-ci sont réalisées de manière à définir une zone latérale 3 qui entoure les structures semiconductrices 20 dans laquelle sont destinées à être situées une surface libre 14 de la couche de nucléation 13 et une surface conductrice 31 d'une électrode de travail 30.

Pour cela, on réalise ensuite un élargissement du premier masque de croissance 1 de manière à recouvrir partiellement la face supérieure de la couche de nucléation 13 (fig.iC). Cet élargissement est avantageux pour obtenir une surface libre 14 de la couche de nucléation 13 permettant d'optimiser la réaction d'ablation électrochimique lors de l'étape de séparation. De plus, le masque de croissance 2 présente ici une épaisseur finale supérieure à l'épaisseur initiale du masque de croissance 1, la valeur de l'épaisseur finale étant fonction des dimensions souhaitées des structures semiconductrices 20. Aussi, une deuxième couche diélectrique est déposée de manière à recouvrir entièrement la couche de nucléation 13 et le premier masque de croissance 1. La deuxième couche diélectrique est de préférence réalisée en un matériau identique à celui du premier masque de croissance, et présente une épaisseur sensiblement égale à la valeur finale souhaitée.

On réalise ensuite, par des techniques de photolithographie et de gravure, des ouvertures traversantes 2a dans la deuxième couche diélectrique, de manière à rendre localement libre une surface des couches de nucléation 13. Chaque bande diélectrique 2 présente l'épaisseur finale, et une largeur finale supérieure à la largeur initiale du masque de croissance 1. En d'autres termes, chaque bande diélectrique 2 du masque de croissance recouvre latéralement, c'est-à-dire transversalement à son étendue longitudinale, une partie de la couche de nucléation 13. Cette partie recouverte est destinée à former la surface libre 14 de la couche de nucléation 13. Par ailleurs, les bandes diélectriques 2 sont destinées à former ultérieurement la zone latérale 3 dans laquelle seront situées la surface libre 14 de la couche de nucléation 13 et la surface conductrice 31 de l'électrode de travail 30.

La section des ouvertures traversantes 2a dans le plan XY peut présenter différentes formes, par exemple circulaire, ovale, polygonale, par exemple carrée ou rectangulaire. Les ouvertures traversantes 2a peuvent présenter des dimensions latérales, dans le plan XY, comprises entre quelques centaines de nanomètres et quelques millimètres, selon les applications visées. Dans cet exemple, la surface de nucléation présente une forme carrée de 50µm de côté, et les bandes diélectriques 2 présentent une largeur finale de 65µm environ.

On réalise ensuite les structures semiconductrices 20 dans les ouvertures traversantes 2a du masque de croissance 2, par croissance épitaxiale de type van der Waals à partir des surfaces de nucléation (fig.iD). Dans cet exemple, les structures semiconductrices 20 sont des empilements de couches semiconductrices réalisées à base d'InGaN et formant une jonction pn, destinés à former des diodes électroluminescentes.

La croissance épitaxiale des structures semiconductrices 20 peut être effectuée par des techniques classiques d'épitaxie, telle que le dépôt CVD, par exemple MOCVD, l'épitaxie MBE, l'épitaxie HVPE, l'épitaxie par couche atomique (ALE, pour *Atomic Layer Epitaxy*), le dépôt par couche atomique (ALD, pour *Atomic Layer Deposition*), voire par évaporation ou pulvérisation cathodique (*sputtering,* en anglais). A titre illustratif, les structures semiconductrices 20 sont réalisées à base d'InGaN par dépôt chimique MOCVD.

A titre illustratif, chaque structure semiconductrice 20 comporte ici, à partir de la surface de nucléation, une portion d'InGaN intrinsèque 21 (non intentionnellement dopé), une première portion 22 dopée selon un premier type de conductivité, par exemple de type n, une zone active 23 formée de plusieurs puits quantiques intercalés chacun entre deux couches barrières, et une deuxième portion 24 dopée selon un deuxième type de conductivité opposé au premier type, par exemple de type p. Les types de conductivité peuvent être inversés. D'autres couches (non représentées) peuvent être prévues, par exemple une couche de blocage d'électrons située entre la zone active et la portion dopée p, et une portion surdopée p destinée à faciliter l'injection des porteurs de charge à partir d'un contact électrique.

Les structures semiconductrices 20 sont ici réalisées de manière collective, c'est-à-dire simultanément, de sorte que les portions dopées 22, 24 et la zone active 23 de chaque structure semiconductrice 20 présentent avantageusement sensiblement les mêmes caractéristiques en termes de dimensions, de composition, et de niveau de dopage.

La portion 21 d'InGaN intrinsèque étant réalisée par épitaxie van der Waals à partir du matériau bidimensionnel de la couche de nucléation 13, elle présente un réseau cristallin qui n'est pas contraint mécaniquement par celui de la couche de nucléation 13, ni par celui du substrat support 11. Ainsi, le paramètre de maille effectif du matériau de la portion 21 d'InGaN intrinsèque est sensiblement égal à sa valeur à l'état naturel (non contraint). Cela se traduit par une bonne relaxation des contraintes mécaniques du matériau de la portion d'InGaN intrinsèque suivant toute son épaisseur, conduisant ainsi à une faible densité de défauts structuraux tels que les dislocations de désaccord de maille issues d'une éventuelle relaxation plastique des contraintes. Ainsi, il est alors possible de réaliser des portions dopées 22, 23, 24 formant la jonction pn dont l'épaisseur n'est plus limitée par l'épaisseur critique à partir de laquelle une relaxation plastique des contraintes mécaniques apparaît habituellement, améliorant ainsi le rendement quantique interne des structures semiconductrices 20 de type diode électroluminescente ou photodiode. Par ailleurs, dans le cas où le matériau de base de la structure semiconductrice 20 est un composé ternaire ou quaternaire à base de GaN, tel que l'InGaN, il est alors possible d'incorporer une forte quantité d'indium et ainsi obtenir un alliage dont la proportion atomique d'indium est particulièrement élevée, permettant alors d'émettre dans le vert (bande spectrale comprise entre 495nm et 560nm), voire dans le rouge (bande spectrale comprise entre 600nm et 650nm). Dans le cas d'une photodiode à base d'AlGaN, une proportion atomique d'aluminium élevée permet d'absorber un rayonnement lumineux dans l'ultraviolet (bande spectrale comprise entre 100nm et 400nm).

On peut ensuite réaliser (fig.iE) les contacts électriques 25, 26 permettant l'injection des porteurs de charge dans la structure semiconductrice 20. Dans cet exemple, les flancs latéraux de la portion 24 dopée p, de la zone active 23, et d'une partie de la portion 22 dopée n sont gravées de manière à former un décrochement recevant un premier contact électrique 26. Par flanc latéral, on entend une surface qui délimite latéralement, dans le plan XY, un élément, cette surface pouvant être orientée de manière sensiblement parallèle à l'axe Z. De plus, un deuxième contact électrique 25, par exemple réalisée en un matériau transparent au rayonnement lumineux d'émission de la diode, est déposé sur la face supérieure de la portion 24 dopée p. Sur la fig.1E, par souci de clarté, la structure semiconductrice 20 présente un rapport de forme qui ne correspond pas forcément au rapport de forme réel. De plus, le masque de croissance 2 n'est pas représenté. Ainsi, la structure semiconductrice 20 peut présenter une épaisseur de l'ordre de quelques microns à dizaines ou centaines de microns, alors que ses dimensions latérales peuvent aller jusqu'à quelques millimètres.

On effectue ensuite le retrait du masque de croissance 2 (fig.iF). Ainsi, on obtient une pluralité de structures semiconductrices 20 distinctes les unes des autres. Elles sont bordées, i.e. entourées, par une zone latérale 3 qui s'étend entre les flancs latéraux se faisant face de deux structures semiconductrices 20 adjacentes. Les structures semiconductrices 20 ne recouvrent qu'une partie des couches de nucléation 13, de sorte que ces dernières présentent une surface libre 14 dans chaque zone latérale 3. De plus, la face supérieure 11a du substrat support 11 présente une surface libre 12 située entre deux couches de nucléation 13 adjacentes. Cette surface libre 12 est destinée à recevoir une électrode de travail 30. La surface libre 14 de chaque couche de nucléation 13 présente une face supérieure 14a opposée au substrat support 11, et une bordure latérale 14b qui définit la périphérie de la couche de nucléation 13.

En référence aux fig.iG et 1H, on réalise ensuite l'électrode de travail 30 reposant sur le substrat support 11 (fig.iG). Celle-ci est située dans la zone latérale 3, et agencée de manière à laisser libre, partiellement ou totalement, la surface libre 14 de la couche de nucléation 13. L'électrode de travail 30 comporte ainsi une surface conductrice 31, distincte de la couche de nucléation 13 et des structures semiconductrices 20. Dans cet exemple, il n'y a pas contact physique entre l'électrode de travail 30 et les couches de nucléation 13, de sorte que la surface libre 14 n'est pas revêtue par l'électrode de travail 30, ni au niveau de sa face supérieure 14a ni au niveau de sa bordure latérale 14b.

L'électrode de travail 30 est réalisée en un matériau électriquement conducteur. Le matériau peut être un métal, par exemple choisi parmi Au, Pt, TiAu, TiN etc... Il peut également s'agir du matériau bidimensionnel de la couche de nucléation 13 lorsqu'il est électriquement conducteur, voire le matériau du substrat support 11 définissant la face supérieure 11a lorsqu'il est électriquement conducteur.

Dans cet exemple, l'électrode de travail 30 forme un maillage de bandes conductrices (fig.iH) déposées au contact de la face supérieure 11a du substrat support 11 et ici à distance de la couche de nucléation 13. A titre d'exemple, les dimensions en épaisseur et en largeur des bandes conductrices peuvent être comprises entre quelques centaines de nanomètres et quelques microns. L'électrode de travail 30 est électriquement reliée à une source de tension adaptée à lui imposer un potentiel électrique déterminé. Ainsi, les structures semiconductrices 20 sont bordées, ici entourées, par des zones latérales dans lesquelles sont situées une surface conductrice 31 de l'électrode de travail 30, et une surface libre 14 de la couche de nucléation 13. La surface libre 14 est ici formée par une partie de la face supérieure 14a et par les flancs latéraux 14b (bordure latérale) de la couche de nucléation 13. La surface conductrice 31 est formée par la face supérieure et par les flancs latéraux de l'électrode de travail 30.

En référence à la fig.1I, on dispose la structure ainsi obtenue dans un bain d'électrolyte aqueux 50, dans lequel est disposée une deuxième électrode, dite électrode de référence 40, laquelle présente un potentiel électrique fixe. Ainsi, l'électrolyte aqueux 50 vient au contact, dans la zone latérale 3, de la surface conductrice 31 de l'électrode de travail 30, et de la surface libre 14 de la couche de nucléation 13. L'électrolyte aqueux 50 est une solution aqueuse contenant des ions. Il est choisi de manière à présenter une conductivité électrique suffisante. De plus, il est choisi de manière à être inerte vis-à-vis du ou des matériaux des structures semiconductrices 20, de manière à ne pas induire de dégradation structurelle. L'électrolyte aqueux 50 peut être acide et présenter un pH par exemple égal à 2 environ. Il peut s'agir de LiCl1M d'une conductivité égale à 70mS.cm. Une contre-électrode par ex. en platine peut être utilisée (montage à trois électrodes), et l'électrode de référence 40 peut être en Ag/AgCl ou au calomel (ou toute autre électrode de référence compatible avec l'électrolyte).

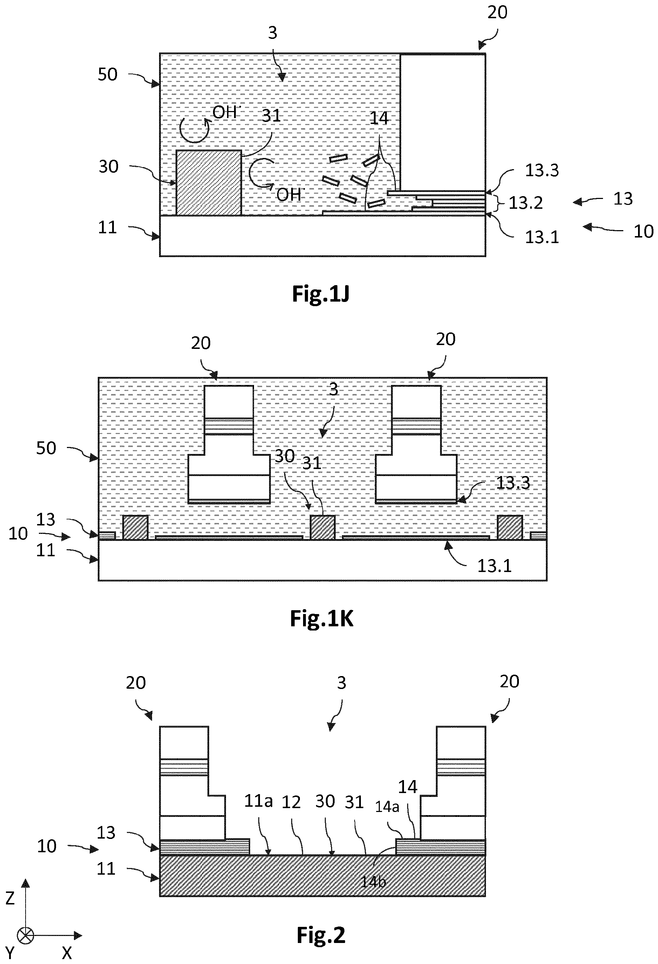

En référence aux fig. 1J et 1K, on effectue ensuite la séparation des structures semiconductrices 20 vis-à-vis du substrat de croissance 10. Pour cela, on applique une différence de potentiel entre l'électrode de travail 30 et l'électrode de référence 40. Le potentiel peut être appliqué en mode continu ou en mode pulsé. Le potentiel présente une valeur suffisante pour générer des radicaux hydroxyles HO· dans l'électrolyte aqueux 50, à l'interface avec la surface conductrice 31 de l'électrode de travail 30. Cette valeur varie en fonction de la nature de l'électrode et de la composition et du pH de l'électrolyte. Les radicaux hydroxyles correspondent aux radicaux libres HO·, c'est-à-dire à la forme neutre des ions hydroxydes OH-. Cette formation de radicaux hydroxyles peut s'accompagner d'une oxydation de la surface conductrice 31, comme indiqué dans l'article d'Avasarala et al. intitulé Electrochemical oxidation behavior of titanium nitride based electrocatalysts under PEMfuel cell conditions, Electrochimica Acta, 55 (2010) 9024-9034, dans le cas d'une électrode en TiN en conditions oxydantes à une tension continue de l'ordre de 1,0V à 1,5V. Dans le cas d'une électrode de travail 30 en nitrure d'un métal de transition, la génération de radicaux hydroxyles peut s'accompagner d'une formation d'azote N₂ gazeux susceptible d'induire un décollement localisé de la couche de nucléation 13, pouvant alors améliorer la séparation des structures semiconductrices 20 vis-à-vis du substrat de croissance 10. La séparation est effectuée par dégradation partielle ou totale d'au moins une monocouche intercalaire 13.2 du matériau bidimensionnel de la couche de nucléation 13, à partir de la surface libre 14, et ici à partir d'au moins sa bordure latérale 14b, par un phénomène d'ablation électrochimique similaire à celui décrit dans l'article de Das et al. intitulé A Self-Limiting Electro-Ablation Technique for the Top-Down Synthesis of Large-Area Monolayer Flakes of 2D Materials, Sci. Rep. 6, 28195 (2016). La valeur minimale du potentiel électrique imposé à l'électrode de travail 30 pour provoquer la génération des radicaux hydroxyles, peut être prédéterminée par une méthode de voltampérométrie impulsionnelle différentielle (DPV pour *Differential Pulse Voltammetry*, en anglais).

Comme l'illustre la fig.1J, du fait du fort pouvoir oxydant des radicaux hydroxyles, ces derniers attaquent directement les liaisons chimiques du matériau bidimensionnel (en bordure des monocouches) à partir de la surface libre 14 de la couche de nucléation 13, et ici à partir de sa bordure latérale 14b. Ainsi, les radicaux hydroxyles sont adsorbés par les monocouches du matériau bidimensionnel, ici à partir du flanc latéral et de la face supérieure libre de la couche de nucléation 13, notamment via des défauts structurels de surface tels que des dislocations.

De manière similaire au phénomène décrit dans l'article de Das 2016, l'adsorption des radicaux hydroxyles provoque la dégradation progressive de la ou des monocouches intercalaires 13.2, par la formation d'une pluralité de feuillets se dissociant de la couche de nucléation 13. Les feuillets issus des monocouches intercalaires 13.2 se dissocient de la couche de nucléation 13 d'autant plus aisément que leur énergie de liaison avec les autres monocouches est inférieure à celle reliant la monocouche inférieure 13.1 au substrat support 11, et à celle reliant la monocouche supérieure 13.3 à la structure semiconductrice 20. Ainsi, comme l'indique la publication de Das et al. 2016, l'énergie de liaison entre une monocouche inférieure en MoS₂ et une surface en TiN, en valeur absolue, est de l'ordre de 1,25eV, alors qu'elle est de l'ordre de 0,16eV entre les monocouches intercalaires de ce matériau bidimensionnel MoS₂.

Comme l'illustre la fig.1K, du fait de la suppression d'au moins une monocouche intercalaire de la couche de nucléation 13 associée à chaque structure semiconductrice 20, on obtient ainsi la séparation des structures semiconductrices 20 vis-à-vis du substrat support 11. Les structures semiconductrices 20 peuvent ensuite être récupérées en vue de finaliser la fabrication d'un système optoélectronique fonctionnel.

Ainsi, le procédé de fabrication permet de réaliser une ou plusieurs structures semiconductrices 20 par épitaxie van der Waals et de les séparer de leur substrat de croissance 10. L'étape de séparation met à profit une réaction d'ablation électrochimique de la couche de nucléation 13 en le matériau bidimensionnel. Ainsi, les structures semiconductrices 20 ne subissent pas d'action mécanique comme dans l'exemple de l'art antérieur mentionné précédemment, ce qui permet de préserver leurs propriétés optiques et/ou électroniques.

Des modes de réalisation particuliers viennent d'être décrits. Différentes variantes et modifications apparaîtront à l'homme du métier.

Ainsi, comme l'illustre la fig.2, la face supérieure 11a du substrat support 11 peut être définie par un matériau électriquement conducteur. Aussi, la surface libre 12 du substrat support 11, située dans la zone latérale 3, peut donc former la surface conductrice 31 de l'électrode de travail 30. Cette dernière peut ainsi être le matériau conducteur du substrat support 11, relié électriquement à la source de tension.

Par ailleurs, en variante au procédé de fabrication décrit précédemment en référence aux fig. 1A à 1K, les différentes structures semiconductrices 20 peuvent, avant l'étape de séparation, être assemblées ensemble à un même substrat secondaire (non représenté), permettant notamment de réaliser ultérieurement les étapes de structuration et de formation des contacts électriques. Ainsi, l'ensemble obtenu, formé du substrat de croissance 10, des structures semiconductrices 20 et du substrat secondaire, est disposé dans l'électrolyte aqueux 50 et l'étape de séparation est effectuée comme décrit précédemment. On obtient ainsi une pluralité de structures semiconductrices 20, séparées du substrat de croissance 10, et assemblées au substrat secondaire.

Par ailleurs, il est possible de procéder à la séparation collective des structures semiconductrices 20, comme décrit précédemment, ou à la séparation sélective de structures semiconductrices 20 préalablement identifiées. Pour cela, l'électrode de travail 30 est formée d'une pluralité de bandes conductrices distinctes les unes des autres. La polarisation d'une ou plusieurs bandes conductrices adjacentes à la structure semiconductrice 20 identifiée permet de séparer ladite structure semiconductrice 20 de manière sélective. Pour cela, la somme des tensions appliquées aux bandes conductrices adjacentes à la structure semiconductrice choisie permet d'atteindre le potentiel nécessaire à l'amorce de la réaction électrochimique d'ablation (donc au voisinage de la structure choisie).

## Revendications

1. Procédé de fabrication d'au moins une structure semiconductrice (20) séparée d'un substrat support (11), comportant les étapes suivantes :
i) réalisation, à partir d'un substrat support (11), d'une couche de nucléation (13) formée d'un matériau bidimensionnel comportant au moins trois monocouches dont au moins une monocouche intercalaire, chaque monocouche étant formée d'un réseau cristallin bidimensionnel ;
ii) réalisation, par épitaxie à partir de la couche de nucléation (13), d'au moins une structure semiconductrice (20),
∘ de manière à être bordée par une zone latérale (3) dans laquelle la couche de nucléation (13) présente une surface libre (14),
∘ une face supérieure (11a) du substrat support (11), sur laquelle repose la couche de nucléation (13), comportant une première surface (12) non recouverte par la couche de nucléation (13), de sorte que la surface libre (14) présente une face supérieure (14a) et une bordure latérale (14b);
iii) obtention d'une surface conductrice (31) d'une première électrode (30), située dans ladite zone latérale (3) et distincte de ladite surface libre (14) ;
iv) disposition de la structure ainsi obtenue dans un bain d'électrolyte aqueux (50), dans lequel est disposée une deuxième électrode (40), l'électrolyte aqueux (50) venant alors au contact, dans la zone latérale (3), de la surface libre (14) de la couche de nucléation (13) et de la surface conductrice (31) de la première électrode (30) ;
v) application d'une différence de potentiel entre lesdites électrodes (30, 40), adaptée à provoquer la formation de radicaux hydroxyles à l'interface entre la surface conductrice (31) et l'électrolyte aqueux (50), lesquels réagissent alors avec la face supérieure (14a) et la bordure latérale (14b) de la surface libre (14) de la couche de nucléation (13), dégradant alors au moins une monocouche intercalaire de la couche de nucléation (13) jusqu'à provoquer la séparation de la structure semiconductrice (20) vis-à-vis du substrat support (11).

2. Procédé selon la revendication 1, dans lequel l'étape iii) d'obtention de la surface conductrice (31) comporte la réalisation d'une portion métallique (30) formant la première électrode, située dans la zone latérale (3) et au contact de la première surface (12) du substrat support (11).

3. Procédé selon la revendication 1 ou 2, dans lequel la surface conductrice (31) de la première électrode (30) est située à distance de la surface libre (14) de la couche de nucléation (13).

4. Procédé selon la revendication 1 ou 2, dans lequel la première surface (12) est définie par un matériau électriquement conducteur du substrat support (11) lequel forme la première électrode (30), la première surface (12) formant alors la surface conductrice (31).

5. Procédé selon l'une quelconque des revendications 1 à 4, dans lequel, lors de l'étape ii) de réalisation de la structure semiconductrice (20), celle-ci recouvre partiellement la couche de nucléation (13), de sorte que la surface libre (14) de la couche de nucléation (13) est formée au moins en partie par une partie de sa face dite supérieure opposée au substrat support (11).

6. Procédé selon l'une quelconque des revendications 1 à 5, dans lequel le matériau bidimensionnel de la couche de nucléation (13) est choisi parmi les chalcogénures de métaux de transition, le graphène, et le nitrure de bore.

7. Procédé selon l'une quelconque des revendications 1 à 6, dans lequel la structure semiconductrice (30) est une diode adaptée à émettre ou à détecter de la lumière, et est réalisée à base d'un composé semiconducteur III-V ou d'un composé semiconducteur II-VI.

8. Procédé selon l'une quelconque des revendications 1 à 7, dans lequel, lors de l'étape ii), une pluralité de structures semiconductrices (20) sont réalisées à partir de couches de nucléation (13) formées en le matériau bidimensionnel et distinctes les unes des autres, chaque structure semiconductrice (20) étant bordée par une zone latérale (3) dans laquelle est située :
- une surface conductrice (31), et
- une première surface (12) de la face supérieure (11a) du substrat support (11), la première surface (12) étant non recouverte par la couche de nucléation (13).

9. Procédé selon l'une quelconque des revendications 1 à 8, dans lequel, lors de l'étape ii), une pluralité de structures semiconductrices (20) sont réalisées, puis, au moins l'une desdites structures semiconductrices (20) est séparée du substrat support (11) de manière sélective, par l'application d'une différence de potentiel entre une première électrode (30) située dans la zone latérale (3) qui borde la structure semiconductrice (30) à séparer, et la deuxième électrode (40).

## Patentansprüche

1. Verfahren zur Herstellung mindestens einer Halbleiterstruktur (20), die von einem Trägersubstrat (11) getrennt ist, wobei es die folgenden Schritte umfasst:
i) Herstellen, ausgehend von einem Trägersubstrat (11), einer Keimbildungsschicht (13), die aus einem zweidimensionalen Material gebildet ist, welches mindestens drei Monolagen aufweist, wobei mindestens eine davon eine zwischengeschaltete Monolage darstellt, wobei jede der Monolagen aus einem zweidimensionalen Kristallgitter gebildet ist;
ii) Herstellen, durch Epitaxie ausgehend von der Keimbildungsschicht (13), mindestens einer Halbleiterstruktur (20),
o derart, dass an diese ein seitlicher Bereich (3) angrenzt, in welchem die Keimbildungsschicht (13) eine freiliegende Oberfläche (14) aufweist,
o wobei eine Oberseite (11a) des Trägersubstrats (11), auf welcher die Keimbildungsschicht (13) aufliegt, eine erste Oberfläche (12) aufweist, die nicht von der Keimbildungsschicht (13) bedeckt ist, sodass die freiliegende Oberfläche (14) eine Oberseite (14a) und einen seitlichen Rand (14b) aufweist;
iii) Erhalten einer leitfähigen Oberfläche (31) einer ersten Elektrode (30), die sich in dem seitlichen Bereich (3) befindet und sich von der freien Oberfläche (14) unterscheidet;
iv) Anordnen der auf diese Weise erhaltenen Struktur in einem wässrigen Elektrolytenbad (50), in welchem eine zweite Elektrode (40) angeordnet ist, woraufhin der wässrige Elektrolyt (50), in dem seitlichen Bereich (3), mit der freien Oberfläche (14) der Keimbildungsschicht (13) und mit der leitfähigen Oberfläche (31) der ersten Elektrode (30) in Kontakt kommt;
v) Anlegen eines Potenzialunterschieds zwischen den Elektroden (30, 40), der dazu geeignet ist, die Bildung von Hydroxylradikalen an der Grenzfläche zwischen der leitfähigen Oberfläche (31) und dem wässrigen Elektrolyten (50) zu bewirken, woraufhin diese mit der Oberseite (14a) und dem seitlichen Rand (14b) der freiliegenden Fläche (14) der Keimbildungsschicht (13) reagieren, sodass mindestens eine zwischengeschaltete Monolage der Keimbildungsschicht (13) soweit abgebaut wird, dass die Trennung der Halbleiterstruktur (20) vom Trägersubstrat (11) bewirkt wird.

2. Verfahren nach Anspruch 1, wobei der Schritt iii) des Erhaltens der leitfähigen Oberfläche (31) das Herstellen eines metallischen Abschnitts (30) aufweist, welcher die erste Elektrode bildet, wobei er sich im seitlichen Bereich (3) befindet und mit der ersten Oberfläche (12) des Trägersubstrats (11) in Kontakt ist.

3. Verfahren nach Anspruch 1 oder 2, wobei die leitfähige Oberfläche (31) der ersten Elektrode (30) von der freiliegenden Oberfläche (14) der Keimbildungsschicht (13) beabstandet ist.

4. Verfahren nach Anspruch 1 oder 2, wobei die erste Oberfläche (12) begrifflich einem elektrisch leitfähigen Material des Trägersubstrats (11) entspricht, das die erste Elektrode (30) bildet, sodass die erste Oberfläche (12) die leitfähige Oberfläche (31) bildet.

5. Verfahren nach einem beliebigen der Ansprüche 1 bis 4, wobei während des Schrittes ii) des Herstellens der Halbleiterstruktur (20) die letztere teilweise die Keimbildungsschicht (13) bedeckt, sodass die freiliegende Oberfläche (14) der Keimbildungsschicht (13) zumindest teilweise durch einen Abschnitt ihrer sogenannten Oberseite gebildet wird, welche dem Trägersubstrat (11) entgegengesetzt ist.

6. Verfahren nach einem beliebigen der Ansprüche 1 bis 5, wobei das zweidimensionale Material der Keimbildungsschicht (13) aus den Übergangsmetall-Chalkogeniden, Graphen und Bornitrid ausgewählt ist.

7. Verfahren nach einem beliebigen der Ansprüche 1 bis 6, wobei es sich bei der Halbleiterstruktur (30) um eine Diode handelt, die dazu geeignet ist, Licht auszusenden oder zu detektieren, und sie auf einer III-V-Halbleiterverbindung oder einer II-VI-Halbleiterverbindung beruht.

8. Verfahren nach einem beliebigen der Ansprüche 1 bis 7, wobei während des Schrittes ii) eine Mehrzahl von Halbleiterstrukturen (20) ausgehend von Keimbildungsschichten (13) hergestellt wird, welche aus dem zweidimensionalen Material gebildet sind und sich voneinander unterscheiden, wobei an jede Halbleiterstruktur (20) ein seitlicher Bereich (3) angrenzt, in welchem sich Folgendes befindet:
- eine leitfähige Oberfläche (31) und
- eine erste Oberfläche (12) der Oberseite (11a) des Trägersubstrats (11), wobei die erste Oberfläche (12) nicht von der Keimbildungsschicht (13) bedeckt ist.

9. Verfahren nach einem beliebigen der Ansprüche 1 bis 8, wobei während des Schrittes ii) eine Mehrzahl von Halbleiterstrukturen (20) hergestellt wird, um anschließend auf selektive Weise mindestens eine der Halbleiterstrukturen (20) vom Trägersubstrat (11) zu trennen, indem ein Potenzialunterschied zwischen einer ersten Elektrode (30), die sich in dem seitlichen Bereich (3) befindet, welcher an die abzutrennende Halbleiterstruktur (30) angrenzt, und der zweiten Elektrode (40) angelegt wird.

## Claims

1. Process for fabricating at least one semiconductor structure (20) separated from a support substrate (11), comprising the following steps:
i) producing, starting from a support substrate (11), a nucleation layer (13) formed of a two-dimensional material comprising at least three monolayers, including at least one interlayer monolayer, each monolayer being formed of a two-dimensional crystal lattice;
ii) producing, by epitaxy starting from the nucleation layer (13), at least one semiconductor structure (20),
∘ so as to be bordered by a lateral zone (3) in which the nucleation layer (13) has a free surface (14),
∘ an upper face (11a) of the support substrate (11), on which the nucleation layer (13) rests, comprising a first surface (12) not covered by the nucleation layer (13), so that the free surface (14) has an upper face (14a) and a lateral edge (14b);
iii) obtaining a conductive surface (31) of a first electrode (30), located in said lateral zone (3) and different from said free surface (14);
iv) placing the structure thus obtained in an aqueous electrolytic bath (50), in which is placed a second electrode (40), the aqueous electrolyte (50) then coming into contact, in the lateral zone (3), with the free surface (14) of the nucleation layer (13) and with the conductive surface (31) of the first electrode (30);
v) applying a potential difference between said electrodes (30,40), suitable for causing the formation of hydroxyl radicals at the interface between the conductive surface (31) and the aqueous electrolyte (50), which then react with the upper face (14a) and the lateral edge (14b) of the free surface (14) of the nucleation layer (13), then degrading at least one interlayer monolayer of the nucleation layer (13) until the separation of the semiconductor structure (20) relative to the support substrate (11) is brought about.

2. Process according to Claim 1, in which step iii) of obtaining the conductive surface (31) comprises the production of a metal portion (30) forming the first electrode, located in the lateral zone (3) and in contact with the first surface (12) of the support substrate (11).

3. Process according to Claim 1 or 2, in which the conductive surface (31) of the first electrode (30) is located at a distance from the free surface (14) of the nucleation layer (13).

4. Process according to Claim 1 or 2, in which the first surface (12) is defined by an electrically conductive material of the support substrate (11) which forms the first electrode (30), the first surface (12) then forming the conductive surface (31).

5. Process according to any one of Claims 1 to 4, in which, during step ii) of producing the semiconductor structure (20), the latter partially covers the nucleation layer (13), so that the free surface (14) of the nucleation layer (13) is formed at least in part by a portion of the so-called upper face thereof opposite the support substrate (11).

6. Process according to any one of Claims 1 to 5, in which the two-dimensional material of the nucleation layer (13) is selected from transition metal chalcogenides, graphene, and boron nitride.

7. Process according to any one of Claims 1 to 6, in which the semiconductor structure (30) is a diode suitable for emitting or detecting light, and is produced using a III-V semiconductor compound or using a II-VI semiconductor compound.

8. Process according to any one of Claims 1 to 7, in which, during step ii), a plurality of semiconductor structures (20) are produced from nucleation layers (13) formed of the two-dimensional material and different from one another, each semiconductor structure (20) being bordered by a lateral zone (3), in which is located:
- a conductive surface (31), and
- a first surface (12) of the upper face (11a) of the support substrate (11), the first surface (12) not being covered by the nucleation layer (13).

9. Process according to any one of Claims 1 to 8, in which, during step ii), a plurality of semiconductor structures (20) are produced, then, at least one of said semiconductor structures (20) is separated from the support substrate (11) selectively, by applying a potential difference between a first electrode (30) located in the lateral zone (3) that borders the semiconductor structure (30) to be separated, and the second electrode (40).
